# EUROPEAN PATENT APPLICATION

(11) **EP 4 187 725 A1**
(43) Date of publication of application: **31.05.2023**
(21) Application number: 21210266.9
(22) Date of filing: 24.11.2021
(51) Int. Cl.: H01S 5/10, H01S 5/042, B82Y 20/00, H01L 33/10, H01S 5/34, H01S 5/22, H01S 5/12

(54) **GRATING RESONATOR**

(71) Applicant: Julius-Maximilians-Universität Würzburg, 97070 Würzburg (DE)
(72) Inventor: Huber, Tobias, 97070 Würzburg (DE); Betzold, Simon, 97072 Würzburg (DE); Höfling, Sven, 97074 Würzburg (DE)
(74) Representative: Lucke, Andreas

(57) **Abstract**

The present disclosure pertains to a grating resonator (1), comprising a central conductive region (11) comprising a first material being a solid; a plurality of confining regions (10) comprising a second material, concentrically arranged around the central conductive region (11), and separated from each other by conductive regions (12) comprising the first material; and an outside region (15) arranged laterally outside a laterally outermost confining region of the plurality of confining regions (10) and comprising the first material. Each of the plurality of conductive regions (12) encompasses an adjacent, laterally inner one of the plurality of confining regions (10); each of the plurality of confining regions (10) encompasses an adjacent, laterally inner one of the plurality of conductive regions (12) and the central conductive region (11); the outside region (15) is suitable for being electrically contacted by a first electrical contact (16) and a second electrical contact (17); a first refractive index of the first material is different from a second refractive index of the second material and a first electrical conductivity of the first material is different from a second electrical conductivity of the second material; each of the plurality of confining regions (10) comprises a ridge or a plurality of ridges (13) that laterally intersect the confining region (10) and that comprise a third material with a third refractive index different from the second refractive index and with a third electrical conductivity different from the second electrical conductivity; and for a first confining region (10a) of the plurality of confining regions (10) comprising first ridges (10a) and a second confining region (10b) of the plurality of confining regions (10) adjacent to the first confining region (10a) comprising second ridges (10b), each first ridge (13a) of the first confining region (10a) is angularly offset from each second ridge (13b) of the second confining region (10b).

## Description

The present disclosure refers to a grating resonator.

### Background

Physical phenomena in optical resonators such as circular grating resonators can be described in terms of quantum electrodynamics, pertaining to the interaction of light and matter. Three major applications arise for optical resonators, namely single photon emitters, light emitting diodes (LEDs), and lasers. Particularly for operating a laser, an optical resonator is necessary. Otherwise, no coherence can be established. By embedding single photon emitters such as quantum dots and LEDs in an optical resonator, efficiency can be increased. The optical resonator generates an optical standing wave that influences the emission properties of the single photon emitter by electric field enhancement.

Circular grating resonators, also called bullseye resonators, represent particularly flat and compact types of optical resonators. Circular grating resonators were first proposed by Scheuer and Yariv (J. Opt. Soc. Am. B 20, 11, pp. 2285-2291 (2003)) and have been used for laser applications (Green et al., Appl. Phys. Lett. 85, 3669 (2004)), for efficiency enhancement in LEDs (Su and Mirin, Appl. Phys. Lett. 89, 033105 (2006)), and for efficiency enhancement in single-photon emitters (Davanco et al., Appl. Phys. Lett. 99, 041102 (2011)). Further advantages of the circular grating resonator are the simple heterojunction structure required when being fabricated from a semiconductor and the possibility to modify the semiconductor band edge by mechanical straining.

Electrical contacting of optical resonators maybe useful for several potential applications, such as electrically pumping the laser, LED, or single photon emitter, introducing single charges into the structure for deterministic carrier control (e.g., for single electron spin experiments), for detuning single photon sources using the Stark effect, or for applying a defined potential to minimize noise due to fluctuating carriers.

In the case of circular grating resonators, however, when for example simply applying an electrical contact to the top side of the resonator, light may be reflected back from the contact and the efficiency may be decreased or even go to zero.

### Summary

It is an object of the present disclosure to provide a grating resonator with improved efficiency for light emission.

For solving the problem, a grating resonator according to independent claim 1 is provided. Further embodiments are disclosed in dependent claims.

According to one aspect, a grating resonator is provided. The grating resonator comprises a central conductive region comprising a first material being a solid. The grating resonator further comprises a plurality of confining regions comprising a second material, concentrically arranged around the central conductive region, and separated from each other by conductive regions which comprise the first material. Moreover, the grating resonator comprises an outside region arranged laterally outside a laterally outermost confining region of the plurality of confining regions and comprising the first material. Each of the plurality of conductive regions encompasses an adjacent, laterally inner one of the plurality of confining regions and each of the plurality of confining regions encompasses an adjacent, laterally inner one of the plurality of conductive regions and the central conductive region. The outside region is suitable for being electrically contacted by a first electrical contact and a second electrical contact. A first refractive index of the first material is different from a second refractive index of the second material and a first electrical conductivity of the first material is different froma second electrical conductivity of the second material. Further, each of the plurality of confining regions comprises a ridge or a plurality of ridges that laterally intersect the confining region and that comprise a third material with a third refractive index different from the second refractive index and with a third electrical conductivity different from the second electrical conductivity. For a first confining region of the plurality of confining regions, which comprises first ridges, and a second confining region of the plurality of confining regions, which is adjacent to the first confining region and comprises second ridges, each first ridge of the first confining region is angularly offset from each second ridge of the second confining region.

The central conductive region may be laterally confined by the laterally innermost confining region, which may comprise a material of different refractive index and may act as a Bragg reflector. Furthermore, the resonator may be vertically confined by further materials of different refractive index from that of the first material, such that optical modes may be created in the central conductive region. The further confining regions may also act as Bragg reflectors and may be arranged such that, due to destructive interference, essentially all light may be emitted from the central conductive region (in the vertical direction).

For electrically pumping (instead of mere optical pumping) within the central conductive region, a voltage may be applied between the first electrical contact and the second electrical contact. Generally, the central conductive region can be directly connected from (vertically) above and below the central conductive region. Such contacting, however, may result in inefficient back-reflection of light from at least one electrical contact and/or undesirable (plasmonic) coupling with material of the electrical contacts. On the other hand, electrically contacting the resonator at the outside region may in general be disadvantageous because of the lower conductivity of the confining regions between the outer region and the central conductive region.

The ridges (bridges) intersecting the confining regions may facilitate the electrical conduction between the electrical contacts via the confining regions and the central conductive region, in particular if confining region segments of the confining region apart from the ridges are of an electrically isolating material. Such ridges would normally not be provided since, in particular, if ridges of adjacent confining regions are angularly aligned with each other, light can leak in a lateral/radial direction so that waveguides are created. As a result, optical modes in the resonator may be destroyed. By angularly offsetting ridges of adjacent confining regions as required by the invention, the creation of such waveguides may be prevented, while still allowing for efficient pumping within the central conductive region.

With the grating resonator according to the invention, electrical operation of miniature lasers based on bullseye resonators may be facilitated, as well as the introduction and detuning of single charge carriers in single photon emitters in bullseye resonators.

The third material (of each ridge) may be the same as the first material (of the conductive regions). Alternatively, the third refractive index may be larger or smaller than the first refractive index. Further, the third electrical conductivity may be larger or smaller than the first electrical conductivity. The ridges may have the same vertical elevation as the conductive regions. The ridges may be regions that have not been etched.

The first refractive index may be greater than the second refractive index. Further, the third refractive index may be greater than the second refractive index. The first refractive index and the third refractive index may be the same or, alternatively, may be different. The first electrical conductivity may be greater than the second electrical conductivity. The third electrical conductivity may be greater than the second electrical conductivity. The first electrical conductivity and the third electrical conductivity may be the same or, alternatively, may be different. The first refractive index may alternatively be less than the second refractive index. Further, the third refractive index may be less than the second refractive index. The first electrical conductivity may be less than the second electrical conductivity. The third electrical conductivity may be less than the second electrical conductivity.

Within the context of the present disclosure, a vertical direction refers to an axial direction parallel to a center axis of the grating resonator and orthogonal to a lateral/radial direction of the grating resonator and orthogonal to an angular (tangential) direction of the grating resonator.

Within the context of the present disclosure, a lateral direction refers to a direction extending outwards from a center point of the grating resonator (arranged in the middle of the central conductive region). In particular, in case of a circular symmetry of the grating resonator, the lateral direction corresponds to a radial direction.

As understood herein, two elements on concentric objects (such as ridges in confining regions) are angularly offset from each other when the elements have different angular positions (relative angles with respect to a reference angle) on the concentric objects. In other words, said two elements are not aligned with each other. Angles are defined with respect to the center point of the grating resonator and in case of rotational symmetry of the grating resonator correspond to polar angles in a polar coordinate system centered around the center point of the grating resonator. In general, an angular direction represents a direction which is (substantially) orthogonal to a lateral/radial direction with respect to the center point of the grating resonator. For example, in case of elliptical symmetry, the angular directions correspond to those elliptical coordinates which are constrained between o and 2 π (360°) and whose coordinate lines correspond to confocal ellipses. It may be generally provided that coordinates along angular directions are defined between o and 2 π.

As understood herein, the central conductive region and/or the plurality of conductive regions do not need to be completely conductive throughout the entire region. For example, the central conductive region and/or the plurality of conductive regions may each comprise a layered structure in which some layers are conductive. In particular, e.g. at least one of a top layer and a bottom layer may be conductive, while a center layer may be not conductive. Alternatively, the center layer may be conducive and at least one of the top layer and the bottom layer may be not conductive.

Within the context of the present disclosure, a region comprising the first material can in particular be the central conductive region, one of the conductive regions, or the outside region laterally/radially outside the outermost confining region. Within the context of the present disclosure, two confining regions are adjacent to each other if no further confining region is arranged between said two confining regions. Further, one of the first regions and one of the second regions are adjacent to each other if they are in physical contact to each other.

The first and the second confining region may be any pair of adjacent confining regions. In particular, the first confining region may be a laterally/radially outer confining region and the second confining region a laterally/radially inner confining region or vice versa. The first confining region may also be an innermost (outermost) confining region and the second confining region may be a second innermost (outermost) confining region. The first confining region may also be any confining region between the innermost and the outermost confining region and the second confining region a laterally/radially inner or outer confining region adjacent to the first confining region.

The grating resonator maybe made from a semiconductor material. The grating resonator may comprise between 2 and 15 confining regions, preferably between 3 and 10 confining regions, more preferably between 4 and 9 confining regions, most preferably 7 confining regions. The more confining regions are employed, the higher the efficiency for light emission. It has been observed that for most tested setups, the efficiency gain becomes negligible for more than 7 confining regions.

The grating resonator may have a diameter between, e.g., 1 µm and 300 µm. The central conductive region may have a diameter between, e.g., 500 nm and 2 µm.

The regions comprising the first material, in particular the central conductive region, the conductive regions, and the outside region, may have a vertical width between 50 nm and 200 nm. The confining regions may for example have a vertical width between 45 nm and 200 nm.

The first material may be a semiconductor, preferably a III-V semiconductor, more preferably one of aluminum indium gallium arsenide (AlInGaAs), aluminium gallium arsenide (AlGaAs), indium gallium arsenide (InGaAs), gallium arsenide (GaAs), and indium phosphide (InP). Depending on the choice of the first material, in particular, the medium in the central conductive region, the wavelength of the emitted light can be tuned.

At least one of, preferably each of the central conductive region, the conductive regions, and the outside region may essentially consist of the first material. At least one of, preferably each of the central conductive region, the conductive regions, and the outside region may also essentially consist of the first material and at least one dopant material.

The first material may be Al*_{X}*In*_{Y}*Ga_{1-*X*-*Y*}As with 0 ≤ *X* + *Y* ≤ 1, preferably with X *=* 0 and 0.4 ≤ *Y* ≤ 0.6. Alternatively, it may be provided that Y = 0 and 0.4 ≤ X ≤ 0.6. It may further be provided that X *= Y* = 0.

Alternatively, the first material may be In_{1-*X*}Ga*_{X}*As (indium gallium arsenide) with X being between 0.1 and 0.9, preferably between 0.4 and 0.6. The wavelength of the emitted light can be tuned by varying the amount of indium in indium gallium arsenide and thus the corresponding band gap.

For example, light emitted by the grating resonator may have a wavelength between 300 nm and 4 µm, preferably 800 nm.

The first and/or the second material may be doped. In particular, the first material may be doped with silicon and/or carbon. This way, the first electrical conductivity of the first material may be increased.

One of a vertical top layer and a vertical bottom layer of the first material may be n-doped, and a vertically opposing layer of the first material may be p-doped. As a result, a heterostructure is created or modified within the first material.

Further, a vertical top layer or a vertical bottom layer of the first material may be doped with silicon and the vertical opposing layer of the first material may be doped with carbon. In particular, doping indium gallium arsenide with silicon results in additional electrons as charge carriers, while doping indium gallium arsenide with carbon results in additional holes as charge carriers.

Alternatively, the first material may be an intrinsic (undoped) semiconductor.

The second material may be a dielectric material, preferably air. The second material may also be a solid dielectric material. Air has the advantage of comprising a particularly low refractive index, while a solid dielectric material may result in a resonator with higher mechanical stability. A grating resonator with air as second material can for example be created by partial etching of the first material.

Alternatively, the second material maybe a further semiconductor material.

Each of the plurality of confining regions may be divided into confining region segments by the ridges of the confining region. The confining region segments of each of the plurality of confining regions may have the same sector angle (i.e., arc length of the confining region segment divided by radius of the confining region). Alternatively, for at least one (or for each one) of the plurality of confining regions, a first confining region segment may have a first sector angle different from a second sector angle of a second confining region segment. Each of the plurality of confining regions may be vertically levelled with the conductive regions. Each confining region segment of the plurality of confining regions may be a trench, in particular formed by etching. The central conductive region may have the same vertical elevation as the conductive regions. The central conductive region may also have the same vertical elevation as the confining region segments. The regions comprising the first material may have the same vertical width as the confining regions.

The confining region segments may essentially consist of the second material. The confining region segments may comprise a concentration of dopants different from a further concentration of dopants of the conductive regions.

At least one of, preferably each of the confining region segments may essentially consist of the second material. At least one of, preferably each of the confining region segments may also essentially consist of the second material and at least one dopant material.

The grating resonator may further comprise a metal layer vertically arranged below a bottom side or above a top side of the regions comprising the first and the second material. Thus, light vertically directed towards the metal layer will be reflected and light will only be emitted in the vertically opposite direction.

The metal layer may for example be a gold foil. The metal layer may be vertically spaced apart from the bottom side or from the top side of the regions comprising the first and the second material, for example by a distance between 10 nm and 100 nm. Further, a dielectric layer may be provided between the metal layer and the first and the second material. Thus, plasmonic coupling with the metal layer may be decreased.

Alternatively, the grating resonator may essentially be surrounded only by air.

The regions comprising the first material (the central conductive region, the conductive regions, and the outside region) may be arranged on a substrate, for example the dielectric layer or, alternatively, a further first material layer. The vertical width of the further first material layer has to be small enough such that the light does not leak radially/laterally.

The grating resonator may further comprise a quantum dot embedded within the central conductive region. The quantum dot may preferably be vertically centered and/or laterally centered and/or radially centered within the grating resonator. This way, the grating resonator may serve to increase the efficiency of the quantum dot for emitting single photons. The quantum dot may comprise a semiconductor material different from the first material. The quantum dot may for example have a vertical width of around 5 nm and a diameter of around 20 nm.

The grating resonator may further comprise the first and the second electrical contact. The first electrical contact and the second electrical contact may be angularly separated from each other such that an electrical current may flow through the central conductive region if a voltage is applied between the electrical contacts. Preferably, the first electrical contact may be arranged at a vertical top side of the outside region and the second electrical contact may be arranged at a vertical bottom side of the outside region. As a result, an electrical current may be created which flows between the (vertical) top side of the resonator and the (vertical) bottom side of the resonator. By arranging the first and the second electrical contact at vertically opposing sides, pumping along the entire vertical range of the central conductive region can be achieved. It may also be provided that the first and the second electrical contact are not part of the grating resonator.

The first and/or the second electrical contact may for example be a bond pad or a lead.

In general, the outside region may be suitable for being electrically contacted by the first electrical contact and the second electrical contact at angularly separated locations.

The first electrical contact and the second electrical contact may be angularly separated from each other by between 110° and 180°, preferably by between 125° and 180°, more preferably by 180° (i.e. diametrically opposed to each other). The first electrical contact and the second electrical contact can also be angularly separated from each other by between 110° and 145°.

The first electrical contact and the second electrical contact need not be essentially diametrically opposed to each other in order to allow for electrically pumping the central conductive region. For compactness, an angular alignment different from diametrical opposition can be provided.

For each first ridge, a corresponding second ridge may be angularly offset such that the first ridge and the second ridge do not overlap in an angular direction.

Specifically, it may be provided that angular position intervals of ridges of adjacent confining regions do not overlap. The angular position interval of a ridge defines the angular share of the ridge within the confining region. Angular position intervals of ridges take into account the ridge widths and sector angles of the ridges. For example, if a ridge centered at 90° has a ridge width corresponding to a sector angle of 10° for a certain circumference, its angular position interval is [85°, 95°].

Alternatively, it may be provided that ridges (angular position intervals of ridges) of adjacent confining regions overlap by at most 10°, preferably by at most 5°.

For each first ridge, a corresponding second ridge may be angularly offset by an offset angle between 10° and 350°, preferably between 25° and 335°, more preferably between 40° and 320°, most preferably 90°. The offset angle may be determined from a ridge alignment of a more inner confining region to a ridge alignment of a more outer confining region. Within the context of the present disclosure, angular offsetting outer confining region ridges counterclockwise with respect to inner confining region ridges corresponds to positive offset angles and offset angles are determined from central points of the first and the second ridge, respectively.

For each second ridge, a corresponding third ridge of a third confining region adjacent to the second confining region may be angularly offset by a further offset angle different from the offset angle. Alternatively, for each second ridge, a corresponding third ridge of a third confining region adjacent to the second confining region may be angularly offset by the same offset angle.

Each of the plurality of confining regions may comprise a same number of ridges, preferably an even number of ridges or an odd number of ridges. For example, each of the plurality of confining regions may comprise one, two, three, four, five, or six ridges.

For each pair of two adjacent first and second confining regions of the plurality of confining regions, each first ridge of the first confining region may be angularly offset from each second ridge of the second confining region, preferably such that each first ridge and each second ridge do not overlap in radial and/or lateral direction.

In particular, for each pair of two adjacent first and second confining regions, each first ridge of the first confining region may be angularly offset from a corresponding second ridge of the second confining region by an associated offset angle which is assigned to each pair of two adjacent first and second confining regions. The associated offset angles maybe different for each pair of two adjacent first and second confining regions.

The associated offset angle may also be the same for each pair of two adjacent first and second confining regions. Alternatively, at least a first pair of adjacent confining regions may have an associated offset angle different from a second pair of adjacent confining regions.

The ridges of each confining region may be equiangularly separated from each other. Alternatively, ridges of at least one confining region are not equiangularly separated from each other. The ridges of each confining region (alternatively, for at least one confining region) may be angularly separated by a separation angle of 45°, 60°, 72°, 90°, 120°, or 180°.

For at least one of the plurality of confining regions, the ridges may be aligned with a (n-fold) rotational symmetry, preferably with a 2-fold, 3-fold, 4-fold, 5-fold, or 6-fold rotational symmetry. Preferably, for the laterally/radially innermost confining region, more preferably, for the innermost confining region and the second innermost confining region, the ridges are aligned with a rotational symmetry. In particular, having an at least 3-fold rotational symmetry in the laterally/radially inner confining regions decreases the possibility of mode splitting. Having more than one mode may prevent the establishment of a stable laser.

The grating resonator (itself) may also be rotationally symmetric. Preferably, the grating resonator may be 2-fold, 3-fold, 4-fold, 5-fold, or 6-fold rotationally symmetric.

Each of the ridges of each of the plurality of confining regions may have a ridge width larger than 5 nm, preferably between 10 nm and 200 nm, more preferably 80 nm.

Within the context of the present disclosure, the ridge width is defined along an angular/tangential direction of the confining region. The larger the ridge width, the higher the possible electrical conductivity towards the central conductive region. On the other hand, mode establishment may be impaired for too large ridge widths.

For each pair of laterally and/or radially adjacent confining regions of the plurality of confining regions, ridges of the outer confining region may have a larger ridge width than ridges of the inner confining region. Thus, electrical conductivity towards the central conductive region is increased, while lateral/radial leakage from the central conductive region is decreased.

Alternatively, each of the ridges of each of the plurality of confining regions may have the same ridge width.

Each two adjacent confining regions of the plurality of confining regions may be laterally separated from each other by a lateral distance between 100 nm and 1000 nm. In particular, each two adjacent confining regions of the plurality of confining regions may be radially separated from each other by a lateral distance between 100 nm and 1000 nm. The lateral/radial distance depends on the wavelength of the light to be emitted and can be determined as laid out in, e.g., Scheuer and Yariv, J. Opt. Soc. Am. B 20, 11, pp. 2285-2291 (2003).

Each of the plurality of confining regions may comprise a lateral width and/or radial width between 20 nm and 200 nm. The lateral width and/or the radial width may also be between 40 nm and 180 nm, 50 nm and 160 nm, 70 nm and 130 nm, or 90 nm and 110 nm. Each of the plurality of confining regions may have the same lateral width and/or the same radial width.

An outer contour and/or an inner contour of at least one of the plurality of confining regions, preferably of each one of the plurality of confining regions may comprise one of a polygonal shape, a rectangular shape, a quadratic shape, a circular shape, and an elliptical shape.

Further, an outer contour and/or an inner contour of at least one of the plurality of conductive regions, preferably of each one of the plurality of conductive regions may comprise one of a polygonal shape, a rectangular shape, a quadratic shape, a circular shape, and an elliptical shape. Moreover, an outer contour of the central conductive region may comprise one of a polygonal shape, a rectangular shape, a quadratic shape, a circular shape, and an elliptical shape.

In particular, in case both the outer contour and the inner contour of one of the confining regions comprise a circular shape, a top surface or a bottom surface of the one of the confining regions may comprise an annular shape. Correspondingly, in case both the outer contour and the inner contour of one of the conductive regions comprise a circular shape, a top surface or a bottom surface of the one of the conductive regions may comprise an annular shape. In case the outer contour of the central conductive region comprises a circular shape, a top surface or a bottom surface of the central conductive region may be a circular disk. The grating resonator may be a circular grating resonator.

### Description of exemplary/preferred embodiments

In the following, exemplary embodiments are described with reference to figures.
- Fig. 1: shows a graphical representation of a grating resonator.
- Fig. 2: shows a graphical representation of a grating arrangement.
- Fig. 3: shows a scanning electron microscope image of a grating resonator.
- Fig. 4: shows a plot of the quality factor of a grating resonator as a function of a ridge width.
- Fig. 5: shows a graphical representation of a grating resonator with an elliptical shape.
- Fig. 6: shows a graphical representation of a grating resonator with a quadratic shape.
- Fig. 7: shows a graphical representation of a grating resonator with a rectangular shape.
- Fig. 8: shows a graphical representation of a grating resonator with a polygonal shape.

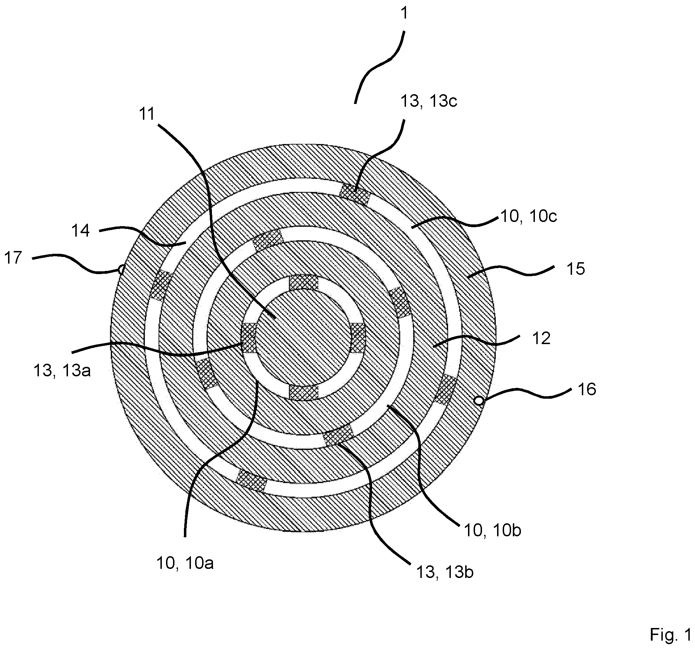

Fig. 1 shows a graphical representation of a grating resonator 1 from a top view. The grating resonator 1 comprises a plurality of confining regions 10 concentrically arranged around a central conductive region 11 and separated from each other by conductive regions 12. The central conductive region 11 and the conductive regions 12 can be made from a first (semiconductor) material such as indium gallium arsenide. Each confining region 10 and each conductive region 12 comprises a top surface (and a bottom surface) with an annular shape. The top surface of the central conductive region 11 has the shape of a circular disk.

The central conductive region 11 is laterally confined by the radially (laterally) innermost confining region 10a, which comprises a second material of lower refractive index than that of the first material and acts as a Bragg reflector. The grating resonator 1 and in particular the central conductive region 11 is moreover vertically confined (not shown) by further materials of lower refractive index than that of the first material, such that optical modes can be created in the central conductive region 11. The further confining regions 10 also comprise the second material, act as Bragg reflectors, and are arranged such that, due to destructive interference, essentially all light is emitted from the central conductive region 11 in a vertical direction (out of or into the shown plane of the grating resonator 1). Below the shown plane of the grating resonator 1, a gold foil may be arranged (not shown) such that essentially all light is emitted vertically out of the plane.

Each confining region 10 comprises ridges (bridges) 13 that radially intersect the confining region 10 and electrically connect the regions 11, 12, 15 surrounding the respective confining region 10. The ridges 13 comprise a third material of larger refractive index and electrical conductivity than that of the second material. The third material can be the same as the first material. As a result, the central conductive region 11 is conductively connected with an outside region 15 outside the outermost confining region of the plurality of confining regions 10. Each confining region 10 is divided by the ridges 13 into confining region segments 14 that may comprise a dielectric material, in particular air, and in the case of etching the semiconductor material correspond to trenches. The ridges 13 maybe formed of the same semiconductor material as the central conductive region 11, the conductive regions 12, and the outside region 15.

For electrically pumping within the central conductive region **11**, an electric current flows through the central conductive region 11. To this end, the outside region 15 is electrically contacted. For example, a first electrical contact 16 and a second electrical contact 17 may be arranged angularly separated from each other at the outside region 15 by such an angle that an electrical current may flow through the central conductive region 11 when a voltage is applied between the first electrical contact 16 and the second electrical contact 17. The first and the second electrical contact 16, 17 may be arranged diametrically with respect to the central point of the grating resonator 1 (corresponding to an angular separation angle of 180°), or depending on the layout of the grating resonator 1, by a smaller angular separation angle, e.g., between 115° and 180°.

The first electrical contact 16 may be arranged at the (shown) vertical top side / top surface of the outside region 15 and the second electrical contact 17 may arranged at the vertical bottom side of the outside region 15. As a result, the electrical current flows between the top side of the resonator 1 and the bottom side of the resonator 1 and the central conductive region 11 can be pumped along its entire vertical range.

For increased conductivity, the first material and/or the third material may further be doped, for example n-type doped at the top side and p-type doped at the bottom side. It may be provided that the second material is not doped.

In the shown embodiment, each ridge 13 of the grating resonator 1 is angularly offset from the ridges 13 of the adjacent confining regions 10. Specifically, each first ridge 13a of a first confining region 10a of the plurality of confining regions 10 is angularly offset from each second ridge 13b of a second confining region 10b of the plurality of confining regions 10 adjacent to the first confining region 10a. Further, each second ridge 13b is angularly offset from each third ridge 13c of a third confining region 10c adjacent to the second confining region 10b. In Fig. 1, the first confining region 10a corresponds to the innermost confining region, the second confining region 10b to the second innermost confining region, and the third confining region 10c to the third innermost confining region. The first, second, and third confining region 10a, 10b, 10c can also each correspond to other radially arranged confining regions, as long as the first and the second confining region 10a, 10b (and the second and the third confining region 10b, 10c) are adjacent to each other, respectively.

As shown in Fig. 1, each confining region 10 is divided by four ridges 13 into four confining region segments 14 of equal sector angle. Each second ridge 13b is offset from each first ridge 13a by a same offset angle of around 25° (i.e., an associated offset angle assigned to the pair of the first confining region 10a and the second confining region 10b is 25°, measured from the radial center of the resonator 1). Furthermore, each third ridge 13c is offset from each second ridge 13b by a further offset angle of roughly 40° (i.e., a further associated offset angle assigned to the pair of the second confining region 10b and the third confining region 10c is 40°). By offsetting the angular positions of the ridges 13, leakage of light can be decreased while providing electrical current from the outside region 15 and the formation of an optical mode maybe maintained in the grating resonator 1.

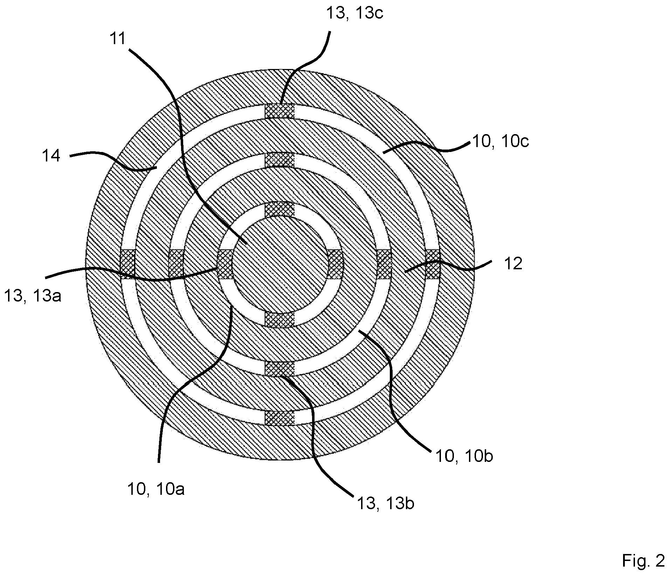

Fig. 2 shows a graphical representation of a grating arrangement not part of the invention. As opposed to the grating resonator 1 of Fig. 1, corresponding first, second, and third ridges 13a, 13b, 13c are angularly aligned with each other. This way, however, radial waveguiding structures are created which may destroy the optical mode in the resonator. This prevents the generation of optical standing waves and thus disturbs the formation of a resonator.

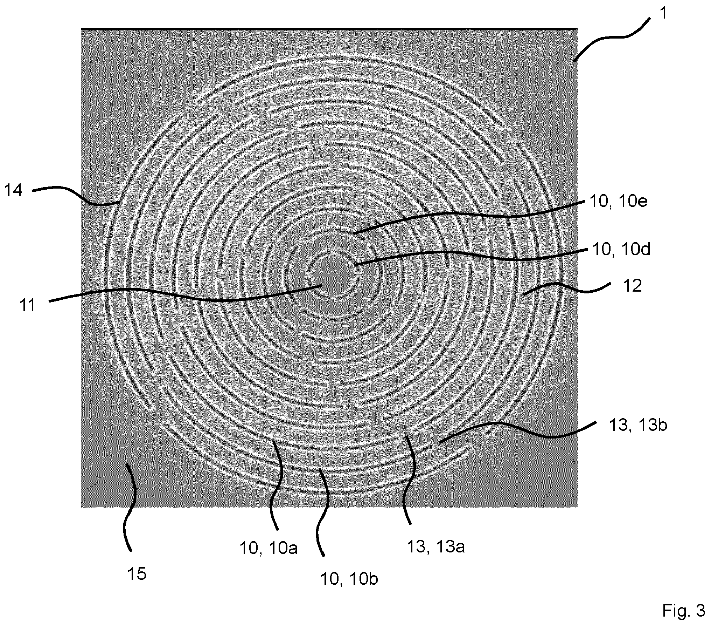

Fig.3 shows a scanning electron microscope image of a grating resonator 1 comprising confining region segments 14 etched into a semiconductor material. Each confining region 10 comprises four ridges 13 dividing each confining region 10 into four confining region segments 14 of roughly 90° sector angle.

For each pair of two adjacent first and second confining regions 10a, 10b, each first ridge 13a of the first (inner) confining region 10a is angularly offset from each second ridge 13b of the second (outer) confining region 10b by an associated offset angle (assigned to the pair of two adjacent first and second confining regions 10a, 10b) between around 5° and 45°. In particular, the associated offset angle of the pair comprising the innermost confining region 10d and the second innermost confining region 10e is around 45°, thus maximizing the angular offset for four ridges 13 per confining region 10 and preserving the optical mode in the central conductive region 11. For more radially outer pairs of confining regions 10 having a smaller influence on the mode formation, the associated offset angles are smaller, leading to higher electrical conductivity. In this regard, ridges 13 provided in confining regions closer to the central conductive region 11 of the grating resonator 1 have a smaller ridge width than those provided in confining regions further away from the central conductive region 11.

Each confining region 10 comprises a 4-fold rotational symmetry. It has been observed that increasing the rotational symmetry from a twofold rotational symmetry towards higher order rotational symmetry, in particular a 3-fold and 4-fold rotational symmetry, mitigates or eliminates mode splitting and yields a single resonator mode, which is generally necessary for stable lasing.

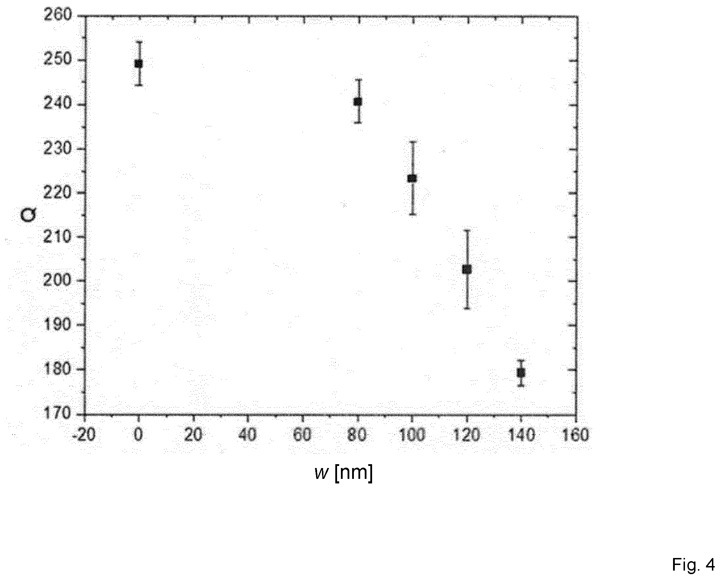

Fig. 4 shows a plot of the quality factor (Q factor) for an embodiment of the grating resonator 1 as a function of a ridge width w in nanometers, depicting the influence of the ridges 13 on the quality factor of the resonator. In this embodiment, the ridge width w is the same for all ridges 13.

At a ridge width of *w* = 80 nm, the (dimensionless) Q factor is within the error bounds of the Q factor without any ridge 13 (i.e., a ridge width of 0 nm). At ridge widths w greater than 100 nm, a noticeable decrease of the Q factor can be observed. Since the mode volume *V*_{mod} in the grating resonator 1 is very small, quality factors above 150 result in very high Purcell factors (which are important for various applications and proportional to Q / *V*_{mod}).

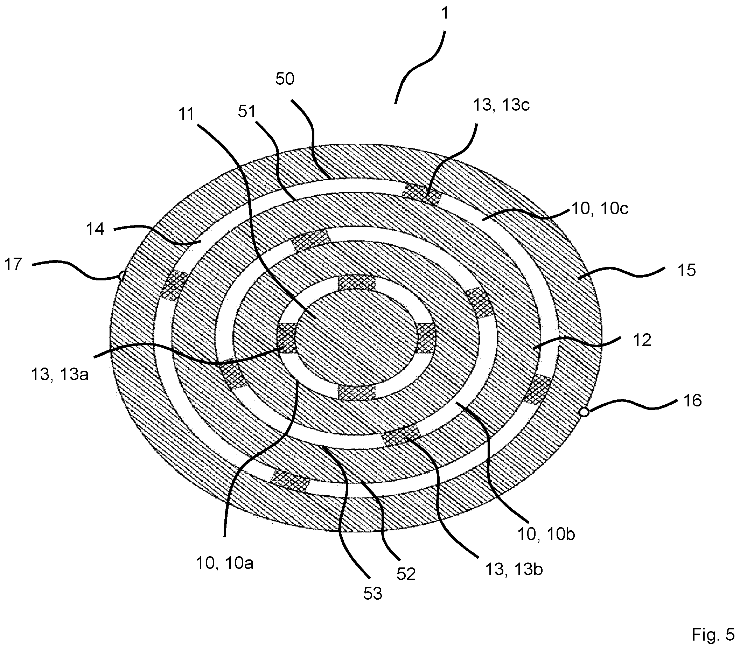

Fig. 5 shows a graphical representation of a grating resonator 1 from a top view with an elliptical shape. Outer contours 50 of the confining regions 10 - as well as inner contours 51 of the confining regions 10, further outer contours 52 of the conductive regions 12, and further inner contours 53 of the conductive regions 12 - each comprise an elliptical shape.

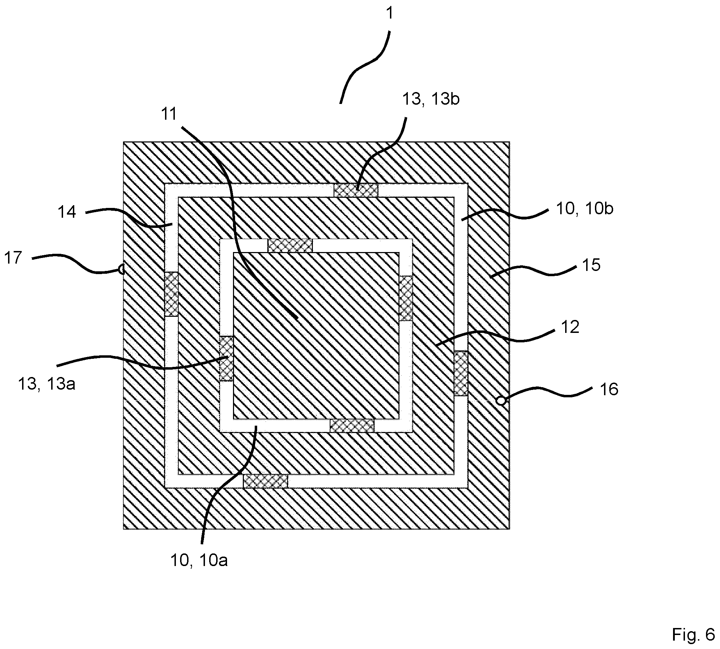

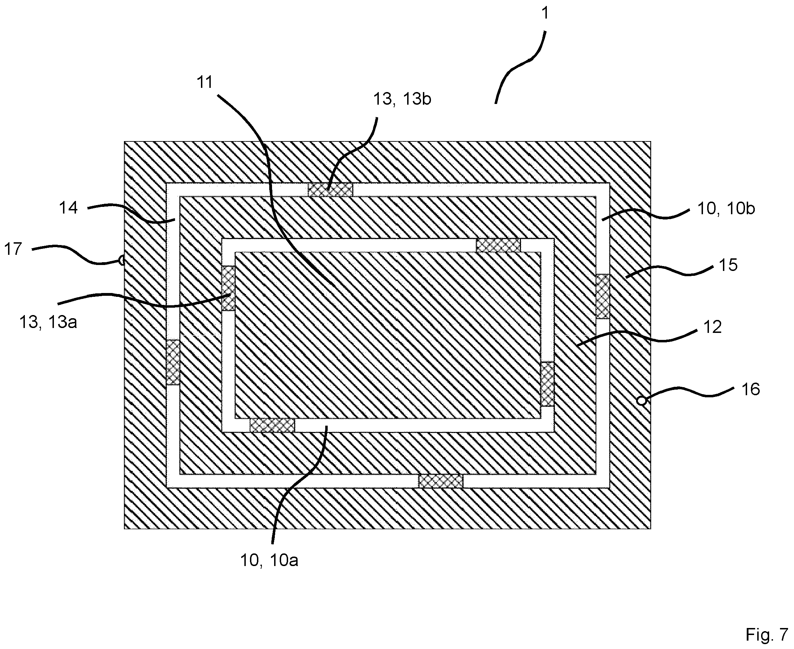

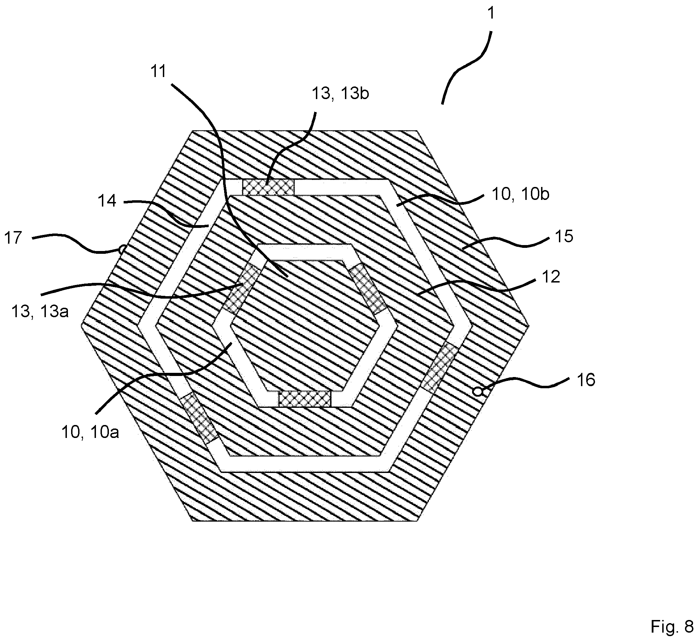

Fig. 6 shows a graphical representation of a grating resonator 1 with a quadratic shape; Fig. 7 shows a graphical representation of a grating resonator 1 with a rectangular shape; and Fig. 8 shows a graphical representation of a grating resonator 1 with a polygonal (hexagonal) shape. As shown in Figs. 6-8, each grating resonator 1 respectively comprises the confining regions 10, 10a, 10b concentrically arranged around the central conductive region 11 and separated from each other by the conductive regions 12. The ridges 13, 13a, 13b of each confining region 10, 10a, 10b laterally intersect the respective confining region 10, 10a, 10b and are angularly offset from each other.

The features disclosed in this specification, the figures and/or the claims may be material for the realization of various embodiments, taken in isolation or in various combinations thereof.

## Claims

1. A grating resonator (1), comprising:
- a central conductive region (11) comprising a first material being a solid;
- a plurality of confining regions (10) comprising a second material, concentrically arranged around the central conductive region (11), and separated from each other by conductive regions (12) comprising the first material; and
- an outside region (15) arranged laterally outside a laterally outermost confining region of the plurality of confining regions (10) and comprising the first material;
wherein
- each of the plurality of conductive regions (12) encompasses an adjacent, laterally inner one of the plurality of confining regions (10);
- each of the plurality of confining regions (10) encompasses an adjacent, laterally inner one of the plurality of conductive regions (12) and the central conductive region (11);
- the outside region (15) is suitable for being electrically contacted by a first electrical contact (16) and a second electrical contact (17);
- a first refractive index of the first material is different from a second refractive index of the second material and a first electrical conductivity of the first material is different from a second electrical conductivity of the second material;
- each of the plurality of confining regions (10) comprises a ridge or a plurality of ridges (13) that laterally intersect the confining region (10) and that comprise a third material with a third refractive index different from the second refractive index and with a third electrical conductivity different from the second electrical conductivity; and
- for a first confining region (10a) of the plurality of confining regions (10) comprising first ridges (10a) and a second confining region (10b) of the plurality of confining regions (10) adjacent to the first confining region (10a) comprising second ridges (10b), each first ridge (13a) of the first confining region (10a) is angularly offset from each second ridge (13b) of the second confining region (10b).

2. The grating resonator (1) of claim 1, wherein the first material is a semiconductor, preferably a III-V semiconductor, more preferably one of aluminum indium gallium arsenide, aluminum gallium arsenide, indium gallium arsenide, gallium arsenide, and indium phosphide.

3. The grating resonator (1) of claim 1 or 2, wherein the first **material** is Al*_{X}*In*_{Y}*Ga_{1-*X*-*Y*}As with 0 ≤ *X* + *Y* ≤ 1, preferably with *X* = 0 and 0.4 ≤ *Y* ≤ 0.6.

4. The grating resonator (1) of claim 2 or 3, wherein the first material is doped with silicon and/or carbon.

5. The grating resonator (1) of one of the preceding claims, wherein one of a vertical top layer and a vertical bottom layer of the first material is n-doped, and a vertically opposing layer of the first material is p-doped.

6. The grating resonator (1) of one of the claims 2 to 5, wherein a vertical top layer or a vertical bottom layer of the first material is doped with silicon and the vertical opposing layer of the first material is doped with carbon.

7. The grating resonator (1) of one of the preceding claims, wherein the second material is a dielectric material, preferably air, and/or further comprising a metal layer vertically arranged below a bottom side or above a top side of the regions comprising the first and/or the second material (10, 11, 12, 15).

8. The grating resonator (1) of one of the preceding claims, further comprising a quantum dot embedded within the central conductive region (11), the quantum dot preferably being vertically and laterally centered within the grating resonator (1).

9. The grating resonator (1) of one of the preceding claims, further comprising the first and the second electrical contact (16, 17), wherein preferably the first electrical contact (16) is arranged at a vertical top side of the outside region (15) and the second electrical contact (17) is arranged at a vertical bottom side of the outside region (15), wherein the first electrical contact (16) and the second electrical contact (17) are preferably angularly separated from each other, preferably by between 110° and 180°, more preferably by between 125° and 180°, most preferably by 180°.

10. The grating resonator (1) of one of the preceding claims, wherein for each first ridge (13a), a corresponding second ridge (13b) is angularly offset such that the first ridge (13a) and the second ridge (13b) do not overlap in an angular direction.

11. The grating resonator (1) of one of the preceding claims, wherein for each first ridge (13a), a corresponding second ridge (13b) is angularly offset by an offset angle between 10° and 350°, preferably between 25° and 335°, more preferably between 40° and 320°, most preferably 90°, wherein preferably, for each second ridge (13b), a corresponding third ridge (13c) of a third confining region (10c) adjacent to the second confining region (10b) is angularly offset by a further offset angle different from the offset angle.

12. The grating resonator (1) of one of the preceding claims, wherein for each pair of two adjacent first and second confining regions (10a, 10b) of the plurality of confining regions (10), each first ridge (13a) of the first confining region (10a) is angularly offset from each second ridge (13b) of the second confining region (10b).

13. The grating resonator (1) of one of the preceding claims, wherein the ridges (13) of each confining region (10) are equiangularly separated from each other, and/or wherein for at least one of the plurality of confining regions (10), the ridges are aligned with a rotational symmetry, preferably with a 2-fold, 3-fold, 4-fold, 5-fold, or 6-fold rotational symmetry.

14. The grating resonator (1) of one of the preceding claims, wherein each of the ridges (13) of each of the plurality of confining regions (10) has a ridge width larger than 5 nm, preferably between 10 nm and 200 nm, more preferably 80 nm, and/or wherein for each pair of adjacent confining regions of the plurality of confining regions, ridges of the outer confining region have a larger ridge width than ridges of the inner confining region.

15. The grating resonator (1) of one of the preceding claims, wherein each two adjacent confining regions of the plurality of confining regions (10) are laterally separated from each other by a lateral distance between 100 nm and 1000 nm, and/or wherein each of the plurality of confining regions (10) comprises a lateral width between 20 nm and 200 nm, and/or wherein an outer contour and/or an inner contour of at least one of the plurality of confining regions (10), preferably of each one of the plurality of confining regions (10) comprises one of a polygonal shape, a rectangular shape, a quadratic shape, a circular shape, and an elliptical shape.

## Amended claims

### Amended claims in accordance with Rule 137(2) EPC.

1. A grating resonator (1), comprising:
- a central conductive region (11) comprising a first material being a solid;
- a plurality of confining regions (10) comprising a second material, concentrically arranged around the central conductive region (11), acting as Bragg reflectors, separated from each other by conductive regions (12) comprising the first material, and being arranged such that light is emitted from the central conductive region (11) in a vertical direction; and
- an outside region (15) arranged laterally outside a laterally outermost confining region of the plurality of confining regions (10) and comprising the first material;
wherein
- each of the plurality of conductive regions (12) encompasses an adjacent, laterally inner one of the plurality of confining regions (10);
- each of the plurality of confining regions (10) encompasses an adjacent, laterally inner one of the plurality of conductive regions (12) and the central conductive region (11);
- the outside region (15) is suitable for being electrically contacted by a first electrical contact (16) and a second electrical contact (17);
- a first refractive index of the first material is different from a second refractive index of the second material and a first electrical conductivity of the first material is different from a second electrical conductivity of the second material;
- each of the plurality of confining regions (10) comprises a ridge or a plurality of ridges (13) that laterally intersect the confining region (10) and that comprise a third material being an electrically conductive material with a third refractive index different from the second refractive index and with a third electrical conductivity different from the second electrical conductivity; and
- for a first confining region (10a) of the plurality of confining regions (10) comprising first ridges (10a) and a second confining region (10b) of the plurality of confining regions (10) adjacent to the first confining region (10a) comprising second ridges (10b), each first ridge (13a) of the first confining region (10a) has, with respect to a center point of the grating resonator (1), a different angular position from each second ridge (13b) of the second confining region (10b).

2. The grating resonator (1) of claim 1, wherein the first material is a semiconductor, preferably a III-V semiconductor, more preferably one of aluminum indium gallium arsenide, aluminum gallium arsenide, indium gallium arsenide, gallium arsenide, and indium phosphide.

3. The grating resonator (1) of claim 1 or 2, wherein the first material is Al*_{X}* In*_{Y}* Ga_{1-*X*-*Y*} As with 0 ≤ *X* + *Y* ≤ 1, preferably with *X* = 0 and 0.4 ≤ Y ≤ 0.6.

4. The grating resonator (1) of claim 2 or 3, wherein the first material is doped with silicon and/or carbon.

5. The grating resonator (1) of one of the preceding claims, wherein one of a vertical top layer and a vertical bottom layer of the first material is n-doped, and a vertically opposing layer of the first material is p-doped.

6. The grating resonator (1) of one of the claims 2 to 5, wherein a vertical top layer or a vertical bottom layer of the first material is doped with silicon and the vertical opposing layer of the first material is doped with carbon.

7. The grating resonator (1) of one of the preceding claims, wherein the second material is a dielectric material, preferably air, and/or further comprising a metal layer vertically arranged below a bottom side or above a top side of the regions comprising the first and/or the second material (10, 11, 12, 15).

8. The grating resonator (1) of one of the preceding claims, further comprising a quantum dot embedded within the central conductive region (11), the quantum dot preferably being vertically and laterally centered within the grating resonator (1).

9. The grating resonator (1) of one of the preceding claims, further comprising the first and the second electrical contact (16, 17), wherein preferably the first electrical contact (16) is arranged at a vertical top side of the outside region (15) and the second electrical contact (17) is arranged at a vertical bottom side of the outside region (15), wherein the first electrical contact (16) and the second electrical contact (17) are preferably angularly separated from each other, preferably by between 110° and 180°, more preferably by between 125° and 180°, most preferably by 180°.

10. The grating resonator (1) of one of the preceding claims, wherein for each first ridge (13a), a corresponding second ridge (13b) is angularly offset such that the first ridge (13a) and the second ridge (13b) do not overlap in an angular direction.

11. The grating resonator (1) of one of the preceding claims, wherein for each first ridge (13a), a corresponding second ridge (13b) has a different angular position with respect to the center point of the grating resonator (1) by an offset angle between 10° and 350°, preferably between 25° and 335°, more preferably between 40° and 320°, most preferably 90°, wherein preferably, for each second ridge (13b), a corresponding third ridge (13c) of a third confining region (10c) adjacent to the second confining region (10b) is angularly offset by a further offset angle different from the offset angle, wherein the offset angle is determined from a ridge alignment of a more inner confining region (10b) to a ridge alignment of a more outer confining region (10c).

12. The grating resonator (1) of one of the preceding claims, wherein for each pair of two adjacent first and second confining regions (10a, 10b) of the plurality of confining regions (10), each first ridge (13a) of the first confining region (10a) is angularly offset from each second ridge (13b) of the second confining region (10b).

13. The grating resonator (1) of one of the preceding claims, wherein the ridges (13) of each confining region (10) are equiangularly separated from each other, and/or wherein for at least one of the plurality of confining regions (10), the ridges are aligned with a rotational symmetry, preferably with a 2-fold, 3-fold, 4-fold, 5-fold, or 6-fold rotational symmetry.

14. The grating resonator (1) of one of the preceding claims, wherein each of the ridges (13) of each of the plurality of confining regions (10) has a ridge width larger than 5 nm, preferably between 10 nm and 200 nm, more preferably 80 nm, and/or wherein for each pair of adjacent confining regions of the plurality of confining regions, ridges of the outer confining region have a larger ridge width than ridges of the inner confining region.

15. The grating resonator (1) of one of the preceding claims, wherein each two adjacent confining regions of the plurality of confining regions (10) are laterally separated from each other by a lateral distance between 100 nm and 1000 nm, and/or wherein each of the plurality of confining regions (10) comprises a lateral width between 20 nm and 200 nm, and/or wherein an outer contour and/or an inner contour of at least one of the plurality of confining regions (10), preferably of each one of the plurality of confining regions (10) comprises one of a polygonal shape, a rectangular shape, a quadratic shape, a circular shape, and an elliptical shape.
